(19) Europäisches Patentamt
European Patent Office
Office européen des brevets

(11) **EP 2 680 017 A1**

(12) **EUROPEAN PATENT APPLICATION**

(43) Date of publication:
**01.01.2014 Bulletin 2014/01**

(51) Int Cl.:
**G01R 31/08** (2006.01)

(21) Application number: **12460036.2**

(22) Date of filing: **28.06.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **ABB Technology AG**
**8050 Zürich (CH)**

(72) Inventors:
• **Dawidowski, Pawel**
  **59-220 Legnica (PL)**
• **Balcerek, Przemyslaw**
  **30-389 Krakow (PL)**

(74) Representative: **Chochorowska-Winiarska, Krystyna**
**ABB Sp. z o. o.,**
**Ul. Zeganska 1**
**04-713 Warszawa (PL)**

(54) **A method of early detection of feeder lines with a high-ohm ground fault in compensated power networks**

(57)     The invention deals with a method of early detection of feeder lines with a high-ohm ground fault in compensated power networks. The method permits indication of the feeder line in which a ground fault occurred, which facilitates its later precise location. The method is executed in the following steps. An auxiliary current signal ($I_{inj}$) of a fixed frequency ($f_{inj}$) is cyclically injected into the distribution network, and at the same time the zero sequence currents of each feeder line ($F_1$, $F_2$, ... $F_n$) are measured in order to calculate the current phasors for zero sequence component ($\underline{I}_{10}$, $\underline{I}_{20}$, ... $\underline{I}_{n0}$) for the frequency ($f_{inj}$), and also phase currents are measured in order to calculate current phasors for positive sequence components ($\underline{I}_{F11}$, $\underline{I}_{F21}$, ... $\underline{I}_{Fn1}$) and current phasors for negative sequence components ($\underline{I}_{F12}$, $\underline{I}_{F22}$, ... $\underline{I}_{Fn2}$) for the fixed frequency ($f_{inj}$). Occurrence of a short circuit is indicated based on the measured current phasors. An additional current signal of the same parameters as the auxiliary signal is injected into the power network and concurrently additional phasors ($\underline{I}_{10\_add}$, $\underline{I}_{20\_add}$, ... $\underline{U}_{n0\_add}$) are measured and determined for the frequency ($f_{inj}$). Fault location coefficients are calculated for each feeder line on the basis of the phasors obtained as a result of the injection of the auxiliary signal and the additional signal. Location of the short circuit is established by checking the interrelation between the calculated fault coefficients and a message about the defect in the indicated line is generated.

Fig.1

**EP 2 680 017 A1**

**Description**

The invention relates to early detection of feeder lines with a high-ohm ground fault in compensated power networks. The method allows an indication of the feeder line in which a ground fault has occurred, which facilitates its later precise location. The method is applicable to compensated medium voltage distribution networks.

BACKGROUND OF THE INVENTION

The most frequently occurring disturbances in distribution networks are ground faults of a high-ohm character, so called non-permanent ground faults, and ground faults of a low-ohm character, so called permanent ground faults. With non-permanent ground faults, leakage currents during a fault condition are orders of magnitude less than currents occurring with permanent ground faults. A high-ohm fault may occur e.g. when a tree branch props against an overhead line or if the power cable insulation was mechanically damaged in the factory. Such fault can develop with time into a permanent ground fault. Then, full phase voltage appears on the shorted network element which normally has the ground potential, which usually poses a great threat to people and equipment. Identification of faults and their detection, i.e. indication of the line in which the fault occurred, is especially difficult in compensated networks, i.e. networks in which the neutral point of the network is connected with the ground by means of an arc-suppression coil, usually a compensation reactor. The purpose of the reactor is to compensate for the capacitive component of fault current. In compensated networks, during normal operation, the occurring ground currents flowing through the line capacitance are so large that if an additional fault current resulting from the occurrence of a high-ohm fault appears, it will affect the value of the total ground current only slightly, which will make its measurement difficult. Moreover, the basic difficulty in fault detection is the fact that an additional ground-fault current which occurs in the defective line occurs also in undamaged lines, which makes simple indication of a faulted line impossible. This is the consequence of the fact that fault current in a compensated system closes through the capacitances of all the transmission lines of the network, both the damaged one and the undamaged ones.

Known fault detection methods include passive methods applicable to low-ohm faults and active methods used to detect high-ohm faults. Passive methods consist in current and voltage measurements in different points of the network and in suitable reaction of the protection automatics depending on the obtained values and arbitrarily set threshold values. Active methods consist by injecting a special current signal into the network and a simultaneous measurement of the current signal and measurement of zero sequence voltage in different points of the network.

Patent application DE10307972 describes an active method of detection of ground faults, both low-ohm and high-ohm, applicable to compensated networks. It consists in introducing an alternating current signal into the network, which signal is a combination of two frequencies near the resonance frequency of the network. After the injection of the alternating current signal, the zero sequence voltage and the current flowing through individual feeder lines of the network are measured in order to calculate the equivalent admittances of individual feeder lines. The obtained values of the measured and calculated admittances are the basis for detecting the fault by indicating in which feeder line the fault occurred and whether the fault is high- or low-ohm. However, the active method of ground fault detection is applicable only to faults occurring in steady state.

SUMMARY OF THE INVENTION

The method of detection of feeder lines with a high-ohm ground fault in compensated power networks is characterized by the following steps.

- Cyclical injection into the power network, through an auxiliary signal source, of an auxiliary current signal $I_{inj}$ of a fixed frequency $f_{inj}$ and of a fixed duration $T_{inj}$ with a simultaneous measurement of zero sequence currents of each feeder line $F_1, F_2, ... F_n$ in order to calculate current phasors for zero sequence components $\underline{I}_{10}, \underline{I}_{20},... \underline{I}_{n0}$ for the frequency $f_{inj}$, and also measurement of phase currents in order to calculate current phasors for positive sequence components $\underline{I}_{F11}, \underline{I}_{F21}, ... \underline{I}_{Fn1}$ and current phasors for negative sequence components $\underline{I}_{F12}, \underline{I}_{F22}, ...\underline{I}_{Fn2}$ for the stable frequency $f_{inj}$, and then recording and storage of the calculated values.

- Indication of the occurrence of a fault based on the calculated current phasors for zero sequence components $\underline{I}_{10}, \underline{I}_{20},... \underline{I}_{n0}$, current phasors for positive sequence components $\underline{I}_{F11}, \underline{I}_{F21},... \underline{I}_{Fn1}$ and current phasors for negative sequence components $\underline{I}_{F12}, \underline{I}_{F22},... \underline{I}_{Fn2}$ based on a known fault detection method based on symmetrical components.

- Injection into the power network, through an auxiliary signal source, of an additional current signal $I_{inj\_add}$ of the same electric parameters as the auxiliary current signal $I_{inj}$ and measurement of zero sequence currents in each feeder line $F_1, F_2, ... F_n$ in order to calculate the values of additional current phasors for zero sequence components $\underline{I}_{10\_add}, \underline{I}_{20\_add},... \underline{I}_{n0-add}$ for the frequency $f_{inj}$, which are then recorded in a database or stored in the memory module of the computer system.

- Grouping into pairs the values of the additional current phasors for the zero sequence components $\underline{I}_{10\_add}, \underline{I}_{20\_add},.... \underline{I}_{n0\_add}$ and the values of the current phasors for the zero sequence components $\underline{I}_{10}, \underline{I}_{20}, ...\underline{I}_{n0}$ obtained as a result of the injection of the auxiliary signal $I_{inj}$, which were previously recorded in the database or stored in the memory of the computer system as a recording or storage from the last measurement before the injection of the additional signal $I_{inj\_add}$, and calculation of fault location coefficients $c_1$, $c_2$, ... $c_n$, for each pair of phasors $(\underline{I}_{10}, \underline{I}_{10\_add})$, $(\underline{I}_{20}, \underline{I}_{20\_add})$, ...$(\underline{I}_{n0}, \underline{I}_{n0\_add})$ according to this formula:

$$ c_i = \left| \frac{\underline{I}_{i0\_add}}{\underline{I}_{i0}} \right| $$

where:

$\underline{I}_{i0\_add}$- is a phasor calculated for a feeder line after the injection of the additional current signal $I_{inj\_add}$,
$\underline{I}_{i0\_}$ is a phasor calculated for a feeder line after the injection of the last auxiliary current signal $I_{inj}$,
$i$ - is the number of the feeder line within the range from 1 to $n$, where $n$ is a natural number.

• Establishment of the location of the high-ohm fault by verifying the condition whether one of the fault location coefficients $(c_1, c_2, ... c_n)$ is larger than value of one while the other coefficients are less than value of one, or whether one of the fault location coefficients $(c_1, c_2, ... c_n)$ is less than value of one while the other coefficients are larger than value of one, and if this condition is fulfilled, then the index i determines the number of the feeder line in which the high-ohm fault occurred.
• Generation of a message about a fault in the indicated line.

Preferably, the frequency $f_{inj}$ of the auxiliary current signal $I_{inj}$ is half of the basic frequency.
Preferably, the auxiliary current signal $I_{inj}$ is introduced cyclically every 5 to 30 min.
Preferably, the duration $T_{inj}$ of the auxiliary current signal $I_{inj}$ is within the range from 5 to 30 seconds.
The method according to the invention enables detection of high-ohm ground faults in compensated networks both in steady states and in transient states. By introducing into the network a signal characterized by only one specific frequency we achieve simplification of measurements and the calculations required to detect a fault are also simplified, which saves time necessary to detect a fault. Measurements of currents in individual feeder lines leading out of measuring stations are enough to detect a fault and to indicate the line in which it occurred. In this method, admittance calculations are not necessary, which eliminates the need of measurements of zero sequence voltage in order to detect a ground fault.

BRIEF DESCRIPTION OF THE DRAWINGS

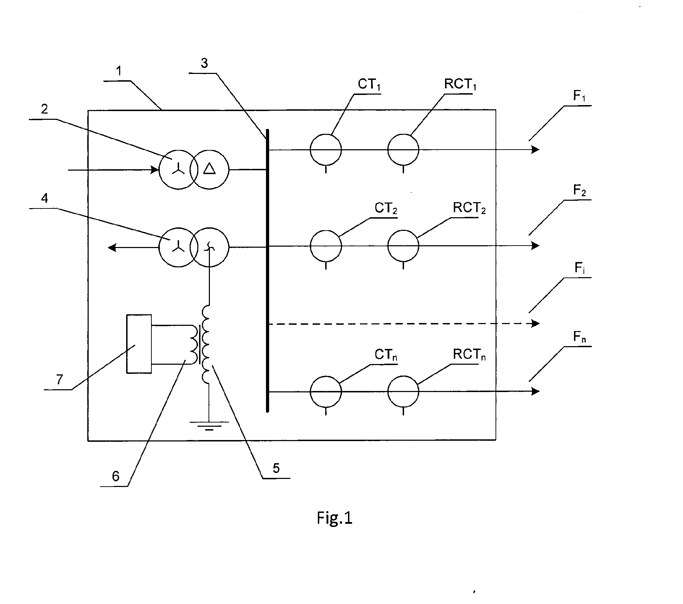

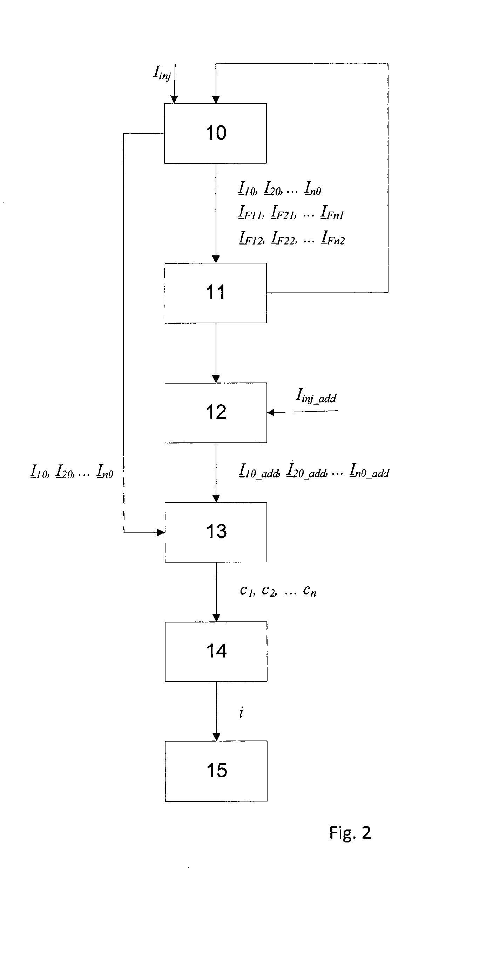

The method according to the invention is explained in its embodiment and on the basis of the drawing where fig. 1 shows schematically the elements of a power substation of a compensated medium voltage distribution network which are essential for this solution, and fig. 2 shows the flow chart for the fault detection process.

DETAILED DESCRIPTION OF THE INVENTION

A three-phase compensated distribution network is schematically shown in the form of a power substation 1 comprising a supply transformer 2 connected with a busbar 3, and a grounding transformer 4 supplied by current flowing through the busbar 3. A shunt reactor 5, in the form of a compensation reactor, is connected to the neutral point of the transformer winding, i.e. to the star point of the transformer 4. The coil of the reactor 5 is provided with a power auxiliary winding 6, to which the source of an auxiliary current signal 7 is connected. Feeder lines of the distribution network $F_1$, $F_2$, ... $F_n$, where $n$ is a natural number, are connected to the busbar 3. Each of the feeder lines $F_1$, $F_2$, ... $F_n$ is provided with a device for measuring the zero sequence current in the form of a residual current transformer $RCT_1$, $RCT_2$, ... $RCT_n$, respectively. Each of the feeder lines $F_1$, $F_2$, ... $F_n$ is provided with a device for measuring phase currents in the form of a set of current transformers $CT_1$, $CT_2$, ... $CT_n$, respectively. All the transformers are connected to a computer system, not shown in the drawing, comprising known elements in the form of analog-to-digital converters, filtration modules, calculation modules, memory modules and databases.
The method according to the invention is realized in the following steps marked 10 to 17.

<u>Step 10.</u>

During normal operation of a compensated distribution network of a basic frequency of 50 Hz or 60 Hz, i.e. one operating without a short circuit, an auxiliary current signal $I_{inj}$ of a specific frequency of the auxiliary signal $f_{inj}$ and of a duration of the auxiliary signal $T_{inj}$ is cyclically injected into the distribution network from a source of the auxiliary current signal 7, through a power auxiliary winding 6 and the coil of a reactor 5. The frequency of the auxiliary signal $f_{inj}$ is selected with a view to filtering off the basic frequency of the network in the simplest possible way. Preferably, the frequency of the auxiliary signal should be half of the basic frequency of the network, that is, for a network of a frequency of 50 Hz, $f_{inj}$ it should be 25 Hz, while for a network of a frequency of 60 Hz, $f_{inj}$ it should be 30 Hz. The auxiliary current signal $I_{inj}$ is injected cyclically, by way of example 10 to 20 minutes. The duration of the auxiliary signal $T_{inj}$ usually ranges from 5 to 50 seconds. The values of zero sequence currents are measured by means of residual current transformers

$RCT_1$, $RCT_2$, ... $RCT_n$, in each feeder line $F_1$, $F_2$, ... $F_n$, during the injection of the auxiliary current signal into the network. The measured values are converted to digital form and filtered using a known method in order to obtain the values of current phasors for zero sequence components $\underline{I}_{10}, \underline{I}_{20}, ... \underline{I}_{n0}$, for the frequency of the auxiliary signal $f_{inj}$, which values are then recorded in a database or stored in the memory module of a computer system. Concurrently with the measurement of zero sequence currents in each feeder line $F_1$, $F_2$, ... $F_n$ a continuous measurement of phase currents is made. Phase currents are measured by means of sets of current transformers $CT_1$, $CT_2$, ... $CT_n$, and next, after conversion to digital form, they are filtered and current phasors for positive sequence components $\underline{I}_{F11}$, $\underline{I}_{F21}$, ... $\underline{I}_{Fn1}$ and current phasors for negative sequence components $\underline{I}_{F12}$, $\underline{I}_{F22}$, ... $\underline{I}_{Fn2}$ for the auxiliary signal frequency $f_{inj}$ are calculated.

Step 11.

The measured values of currents and the calculated phasors are used in calculations leading to the indication of the occurrence of a short circuit. These calculations are conducted according to the theory of symmetrical components, known in the state of the art, which describes interrelations between currents for individual symmetrical components during a short circuit. As distinct from the state of the art which is based on measurement of admittance of individual lines, the proposed method is based only on measurement of the transient state of currents for individual symmetrical components. Therefore it does not require an additional measurement of zero sequence voltage.

Step 12.

When an occurrence of a short circuit has been established, no matter whether it is a short circuit in steady or in transient status, an additional current signal $I_{inj\_add}$ of the same parameters as the auxiliary current signal $I_{inj}$ described in step 1 is injected to the distribution network from the source of the auxiliary current signal 7 through the power auxiliary winding 6 and the coil of the reactor 5. The additional current signal $I_{inj\_add}$ has a definite frequency of the auxiliary signal $f_{inj}$ and a definite duration of the auxiliary signal $T_{inj}$.
Concurrently with the injection of the additional current signal $I_{inj-add}$, zero sequence currents are measured on residual current transformers $RCT_1$, $RCT_2$, ... $RCT_n$ in each feeder line $F_1$, $F_2$, ... $F_n$. The measured values are converted to digital form and filtered in a known way in order to obtain the values of the additional current phasors for zero sequence components $\underline{I}_{10\_add}$, $\underline{I}_{20\_add}, ... \underline{I}_{n0\_add}$ for the frequency of the additional current signal $f_{inj}$, which values are then recorded in a database or stored in the memory module of the computer system.

Step 13.

Next, the values of the additional current phasors for the zero sequence components $\underline{I}_{10\_add}$, $\underline{I}_{20\_add}, ... \underline{I}_{i0\_add} ... \underline{I}_{n0\_add}$ and the values of the current phasors for the zero sequence components $\underline{I}_{10}$, $\underline{I}_{20}, ... \underline{I}_{io} ... \underline{I}_{n0}$ obtained as a result of the injection of the auxiliary signal $I_{inj}$, which were previously recorded in the database or stored in the memory of the computer system as a recording or storage from step 10 and step 13, are grouped in pairs, respectively, and for each pair of phasors $(\underline{I}_{10}, \underline{I}_{10-add})$, $(\underline{I}_{20}, \underline{I}_{20\_add})$, ... $(\underline{I}_{i0}, \underline{I}_{i0\_add})$, ... $(\underline{I}_{n0}, \underline{I}_{n0\_add})$ fault location coefficients $c_1$, $c_2$, ... $c_n$ expressed by the below formula are calculated:

$$c_i = \left| \frac{\underline{I}_{i0\_add}}{\underline{I}_{i0}} \right|$$

where:

$\underline{I}_{i0\_add}$ - denotes a phasor calculated for a feeder line after the injection of the additional current signal $I_{inj\_add}$,

$\underline{I}_{i0\_}$ denotes a phasor calculated for a feeder line after the injection of the last auxiliary current signal $I_{inj}$,

$i$ - denotes the number of the examined pair within the range of 1 to $n$, where $n$ is a natural number.

Step 14.

The next action is to check if one of these conditions is fulfilled:

One fault location coefficient $c_i$ from step 13 is larger than value of one, and all the other coefficients are less than value of one.

One fault location coefficient $c_i$ from step 13 is less than value of one, and all the other coefficients are larger than value of one.

If one of the above conditions is fulfilled, it means that a high-ohm fault has occurred in the feeder line with the same index i as the index of the distinguished coefficient $c_i$.

Step 15.

After the determination of the feeder line $F_i$ for the line in which the short circuit has occurred, information about the defective line is transmitted in any way e.g. by displaying the number of the defective line on the computer screen located in the control room of the service team, to help dispatch the repair team as soon as possible.

**Claims**

1. The method of early detection of feeder lines with a high-ohm ground fault in compensated power networks is **characterized by** comprising the following steps:

   • cyclical injection into the power network, through an auxiliary signal source, of an auxiliary current signal ($I_{inj}$) of a fixed frequency ($f_{inj}$) and of a fixed duration ($T_{inj}$) with a simultaneous measurement of zero sequence currents of each feeder line ($F_1, F_2, ... F_n$) in order to calculate current phasors for zero sequence components ($\underline{I}_{10}, \underline{I}_{20}, ... \underline{I}_{n0}$) for the frequency ($f_{inj}$), and also measurement of phase currents in order to calculate current phasors for positive sequence components ($\underline{I}_{F11}, \underline{I}_{F21}, ... \underline{I}_{Fn1}$) and current phasors for negative sequence components ($\underline{I}_{F12}, \underline{I}_{F22}, ... \underline{I}_{Fn2}$) for the stable frequency ($f_{inj}$), and then recording and storage of the calculated values,
   • indication of the occurrence of a fault based on the calculated current phasors for zero sequence components ($\underline{I}_{10}, \underline{I}_{20}, ... \underline{I}_{n0}$), current phasors for positive sequence components ($\underline{I}_{F11}, \underline{I}_{F21}, ... \underline{I}_{Fn1}$) and current phasors for negative sequence components ($\underline{I}_{F12}, \underline{I}_{F22}, ... \underline{I}_{Fn2}$) based on a known fault detection method based on symmetrical components,
   • injection into the power network, through an auxiliary signal source, of an additional current signal ($I_{inj\_add}$) of the same electric parameters as the auxiliary current signal ($I_{inj}$) and measurement of zero sequence currents in each feeder line ($F_1, F_2, ... F_n$) in order to calculate the values of additional current phasors for zero sequence components ($\underline{I}_{10\_add}, \underline{I}_{20\_add}, ... \underline{I}_{n0\_add}$) for the frequency ($f_{inj}$), which are then recorded in a database or stored in the memory module of the computer system,
   • grouping into pairs the values of the additional current phasors for the zero sequence components ($\underline{I}_{10\_add}, \underline{I}_{20\_add}, ... \underline{I}_{n0\_add}$) and the values of the current phasors for the zero sequence components ($\underline{I}_{10}, \underline{I}_{20}, ... \underline{I}_{n0}$) obtained as a result of the injection of the auxiliary signal ($I_{inj}$), which were previously recorded in the database or stored in the memory of the computer system as a recording or storage from the last measurement before the injection of the additional signal ($I_{inj\_add}$), and calculation of fault location coefficients ($c_1, c_2, ... c_n$), for each pair of phasors

($\underline{I}_{10}, \underline{I}_{10\_add}$), ($\underline{I}_{20}, \underline{I}_{20\_}add$), ... ($\underline{I}_{n0}, \underline{I}_{n0\_add}$) according to this formula:

$$c_i = \left| \frac{\underline{I}_{i0\_add}}{\underline{I}_{i0}} \right|$$

where:

   $\underline{I}_{i0\_add}$ is a phasor calculated for a feeder line after the injection of the additional current signal $I_{inj\_add}$,
   $\underline{I}_{i0}$ is a phasor calculated for a feeder line after the injection of the last auxiliary current signal $I_{inj}$,
   $i$ - is the number of the feeder line within the range from 1 to $n$, where $n$ is a natural number,

   • establishment of the location of the high-ohm fault by verifying the condition whether one of the fault location coefficients ($c_1, c_2, ... c_n$) is larger than value of one while the other coefficients are less than value of one, or whether one of the fault location coefficients ($c_1, c_2, ... c_n$) is less than value of one while the other coefficients are larger than value of one, and if this condition is fulfilled, then the index i determines the number of the feeder line in which the high-ohm fault occurred,
   • generation of a message about the fault in the indicated line.

2. A method according to claim 1, **characterized in that** the frequency ($f_{inj}$) of the auxiliary current signal ($I_{inj}$) is half of the basic frequency.

3. A method according to claim 1, **characterized in that** the auxiliary current signal ($I_{inj}$) is introduced cyclically every 5 to 30 min.

4. A method according to claim 1, **characterized in that** the duration ($T_{inj}$) of the auxiliary current signal ($I_{inj}$) is within the range from 5 to 30 seconds.

Fig.1

$I_{inj}$

10

$\underline{I}_{10}, \underline{I}_{20}, \dots \underline{I}_{n0}$
$\underline{I}_{F11}, \underline{I}_{F21}, \dots \underline{I}_{Fn1}$
$\underline{I}_{F12}, \underline{I}_{F22}, \dots \underline{I}_{Fn2}$

11

12     $I_{inj\_add}$

$\underline{I}_{10}, \underline{I}_{20}, \dots \underline{I}_{n0}$     $\underline{I}_{10\_add}, \underline{I}_{20\_add}, \dots \underline{I}_{n0\_add}$

13

$c_1, c_2, \dots c_n$

14

$i$

15

Fig. 2

Europäisches
Patentamt

European
Patent Office

Office européen
des brevets

**EUROPEAN SEARCH REPORT**

Application Number

EP 12 46 0036

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 4 148 087 A (PHADKE ARUN G) 3 April 1979 (1979-04-03) * abstract; claims 1-12; figures 1-16 * * column 3, line 4 - column 18, line 68 * ----- | 1-4 | INV. G01R31/08 |
| A | EP 1 089 081 A2 (ABB SUBSTATION AUTOMATION OY [FI] ABB OY [FI]) 4 April 2001 (2001-04-04) * abstract; claims 1-9; figures 1,2 * * paragraph [0010] - paragraph [0011] * * paragraph [0014] - paragraph [0022] * * paragraph [0024] - paragraph [0088] * ----- | 1-4 | |
| A | US 2007/014059 A1 (ALTONEN JANNE [FI] ET AL) 18 January 2007 (2007-01-18) * abstract; claims 1-10; figures 1-4C * * paragraph [0029] - paragraph [0031] * * paragraph [0037] - paragraph [0086] * ----- | 1-4 | |
| A | US 4 996 624 A (SCHWEITZER III EDMUND O [US]) 26 February 1991 (1991-02-26) * abstract; claims 1-4; figures 1-2 * * column 3, line 18 - line 29 * * column 3, line 42 - column 5, line 14 * ----- | 1-4 | TECHNICAL FIELDS SEARCHED (IPC) G01R |

The present search report has been drawn up for all claims

| Place of search | Date of completion of the search | Examiner |
|---|---|---|
| Munich | 3 December 2012 | Nadal, Rafael |

EPO FORM 1503 03.82 (P04C01)

**ANNEX TO THE EUROPEAN SEARCH REPORT
ON EUROPEAN PATENT APPLICATION NO.**

EP 12 46 0036

This annex lists the patent family members relating to the patent documents cited in the above-mentioned European search report.
The members are as contained in the European Patent Office EDP file on
The European Patent Office is in no way liable for these particulars which are merely given for the purpose of information.

03-12-2012

| Patent document cited in search report | | | Publication date | Patent family member(s) | | | Publication date |
|---|---|---|---|---|---|---|---|
| US 4148087 | A | | 03-04-1979 | NONE | | | |
| EP 1089081 | A2 | | 04-04-2001 | AT | 291235 | T | 15-04-2005 |
| | | | | DE | 60018666 | D1 | 21-04-2005 |
| | | | | DE | 60018666 | T2 | 13-04-2006 |
| | | | | EP | 1089081 | A2 | 04-04-2001 |
| | | | | FI | 106985 | B1 | 15-05-2001 |
| US 2007014059 | A1 | | 18-01-2007 | CN | 1916651 | A | 21-02-2007 |
| | | | | EP | 1739441 | A1 | 03-01-2007 |
| | | | | FI | 20055359 | A | 30-12-2006 |
| | | | | US | 2007014059 | A1 | 18-01-2007 |
| US 4996624 | A | | 26-02-1991 | NONE | | | |

EPO FORM P0459

For more details about this annex : see Official Journal of the European Patent Office, No. 12/82

**REFERENCES CITED IN THE DESCRIPTION**

**Patent documents cited in the description**

- DE 10307972